# EUROPÄISCHE PATENTSCHRIFT

(11) **EP 3 027 700 B1**
(45) Veröffentlichungstag und Bekanntmachung des Hinweises auf die Patenterteilung: **28.12.2016**
(21) Anmeldenummer: 14748156.8
(22) Anmeldetag: 30.07.2014
(51) Int. Cl.: C09D 183/04, H01L 23/29

(54) **SILICONHARZZUSAMMENSETZUNG FÜR OPTISCHE HALBLEITER**
SILICONE RESIN COMPOSITION FOR OPTICAL SEMICONDUCTORS
PRÉPARATION DE POLYORGANOSILOXANE POUR SEMI-CONDUCTEURS OPTIQUES

(30) Priorität: 01.08.2013 DE 102013215102
(43) Veröffentlichungstag der Anmeldung: 08.06.2016
(73) Patentinhaber: Wacker Chemie AG, 81737 München (DE)
(72) Erfinder: SANDMEYER, Frank, 84508 Burgkirchen (DE); FUNK, Enno, 84561 Mehring (DE); LÖSSEL, Georg, 84547 Emmerting (DE)
(74) Vertreter: Mieskes, Klaus Theoderich
(86) Internationale Anmeldenummer: PCT/EP2014/066369
(87) Internationale Veröffentlichungsnummer: WO 2015/014890

(56) Entgegenhaltungen:
- WO-A2-2006/013066
- DE-A1- 10 359 705
- US-A1- 2006 081 864

## Beschreibung

Die Erfindung betrifft Siliconharzzusammensetzungen und deren Verwendung zur Herstellung von optischen Halbleiterelementen.

Die Anforderungen an Vergussmassen zur Herstellung elektrischer und elektronischer Bauteile, insbesondere bei der Herstellung von optischen Halbleiterelementen wie Hochleistungs-LEDs (=light emitting device) sind sehr umfangreich und teilweise gegensätzlich, um eine hohe Lichtausbeute und Lebensdauer der LED zu gewährleisten. Gewünschte Eigenschaften sind beispielsweise:
- gute Oberflächenhärte und Formgebungseigenschaften;
- bei gleichzeitiger Flexibilität;
- gute Licht- und Thermostabilität;
- gute Wetterbeständigkeit;
- geringe Gasdurchlässigkeit und somit Vermeidung von Korrosion;
- hohe Transparenz;
- hoher Brechungsindex;
- keine Vergilbung (Verfärbung durch Wärme);
- gute verfahrenstechnische Eigenschaften bei der Verarbeitung;
- einfache und somit kosteneffiziente Zusammensetzungen und dadurch resultierende kosteneffizientere LED-Herstellmethoden.

Im bisherigen Stand der Technik sind bereits viele Lösungsvorschläge offenbart worden, die allerdings immer nur Teilaspekte dieser Forderung erfüllen konnten.

Viele Schriften offenbaren die Verwendung von additionsvernetzenden Siliconzusammensetzungen für die Herstellung von LEDs. Sie bestehen aus mindestens einem Organopolysiloxan mit mindestens zwei aliphatisch ungesättigten Gruppen im Molekül, sowie mindestens einem Organohydrogenpolysiloxan mit zwei oder mehr Si-H-Gruppen im Molekül und mindestens einem Hydrosilylierungskatalysator und häufig weiteren Additiven.

Folgende beispielhaft genannte Schriften befassen sich mit Lösungsvorschlägen zur Verringerung der Gasdurchlässigkeit. EP2399961B1 beispielsweise offenbart solche additionsvernetztenden Siliconharzzusammensetzungen für LED-Herstellung wobei mindestens ein Antioxidans als weiteres Additiv enthalten sein muss. US20120256325A1 offenbart Siliconharzzusammensetzungen enthaltend ein Aryl-siliconharz mit mindestens 2 Vinylgruppen, einen Additionskatalysator, sowie ein Organohydrogenpolysiloxangemisch bestehend aus zwei verschiedenen Organohydrogenpolysiloxanen mit kettenständigen Si-Aryl-Einheiten, das erste ein Organohydrogenpolysiloxan-Öl mit alpha-omega terminalen Si-H-Gruppen und das zweite ein monofunktionelles Organopolyhydrogensiloxan-Öl mit nur einer terminalen Si-H-Gruppe. Nachteilig ist bei beiden Lösungen deren relativ komplexe Zusammensetzung, die teilweise problematische präparative Zugänglichkeit und damit verbunden deren reduzierte Wirtschaftlichkeit.

Die WO2004/107458A2 offenbart additionsvernetzende Organopolysiloxanzubereitungen, die gegebenenfalls selbstvernetzend sein können enthaltend entweder selbstvernetzende Organopolysiloxane, die Harzbausteine enthalten müssen, die pro Molekül sowohl aliphatisch ungesättigte Gruppen als auch Si-H-Gruppen enthalten oder eine additionsvernetzbare Zubereitung aus Organopolysiloxanen, die auch Harzbausteine enthalten müssen, sowie einen Hydrosilylierungskatalysator. Auch DE10359705A1 offenbart additionsvernetzende Siliconzusammensetzungen, die auch ein selbstvernetzendes Siliconharz enthalten. Der Nachteil der in diesen Schriften beschriebenen Zubereitungen besteht darin, dass sie ausschließlich aus oligomeren oder polymeren Polyorganosiloxanen bestehen und dadurch die Einstellung bestimmter Verarbeitungseigenschaften, vor allem der Viskosität, die je nach gewünschtem Verarbeitungsprozess über einen weiten Bereich variieren kann, sehr erschwert ist. Das hat den nachteiligen Effekt, dass solche Zubereitungen jeweils gezielt für einen bestimmten Verarbeitungsprozess optimiert werden müssen, so dass bei gezielter Verwendung neuer Organopolysiloxane, diese stets mit Anpassungen der Verarbeitungsprozesse verbunden sind oder umgekehrt.

Es besteht daher ein Bedarf an Silikonzusammensetzungen die eine einfache Variabilität aufweisen und gleichzeitig die oben gezeigten Anforderungen erfüllen.

Aufgabe der vorliegenden Erfindung war es somit eine möglichst einfache Siliconzusammensetzung zur Verfügung zu stellen, die dennoch die oben gennannten Anforderung an Vergussmassen für LEDs erfüllt.

Diese Aufgabe wurde durch die erfindungsgemäße additionsvernetzende Siliconharzzusammensetzung gelöst.
Erfindungsgemäße additionsvernetzende Siliconharzzusammensetzungen enthalten
A) mindestens ein verzweigtes, selbstvernetzendes Organopolysiloxan der allgemeinen Formel (I)

   (R¹R2R³SiO_{1/2})_{M} (R⁴R⁵SiO_{2/2})_{D} (R⁶SiO_{3/2})_{T} (SiO_{4/2})_{Q} (I),

   wobei
   - R¹ bis R⁶ unabhängig voneinander, einwertige, gegebenenfalls substituierte Kohlenwasserstoffreste, die durch Heteroatome unterbrochen sein können, eine OH-Gruppe oder ein Wasserstoff-Atom,
   - M, D, T, und Q eine Zahl von 0 bis <1, bedeuten,
   mit der Maßgabe, dass M+D+T+Q=1 und Q+T>0 erfüllt ist, und mit der Maßgabe, dass ein Molekül A) als Reste R¹ bis R⁶
   - mindestens zwei Alkenyl-Gruppen,
   - mindestens zwei Wasserstoff-Atome, und
   - mindestens eine Aryl-Gruppe,
   enthält,
   und mit der Maßgabe, dass mindestens 5 mol-% aller Teileinheiten von A) solche der Form (R⁴R⁵SiO_{2/2})_{D} sind, mit der Maßgabe, dass mindestens 6 mol% aller Teileinheiten (R⁴R⁵SiO_{2/2}) als Kettensegmente aus 3 bis 200 aneinandergereihten Teileinheiten in A) vorliegen und die Reste R⁴ und R⁵ dieser Teileinheiten, die als Kettensegmente vorliegen, weder ein Wasserstoff-Atom noch ein Alkenylrest sind,
   - wobei das molare Verhältnis der siliziumgebundenen Alkenyl-Gruppen tragenden Wiederholungseinheiten zu den siliziumgebundene Wasserstoffatome tragenden Wiederholungseinheiten mindestens 0,75 beträgt; und
   - wobei der Molanteil der mindestens einen Arylrest tragenden Siliziumatome zur Gesamtanzahl der Siliziumatome mindestens 30% beträgt; und
   - wobei der molare Anteil der Alkylgruppen an der Gesamtzahl der siliziumgebundenen Reste höchstens 70% beträgt,
C) eine ausreichende Menge mindestens eines die Anlagerung von Si-gebundenem Wasserstoff an aliphatische Doppelbindungen fördernden Katalysators,
wobei in der additionsvernetzenden Siliconharzzusammensetzung das molare Verhältnis von siliziumgebundenen Alkenyl-Gruppen zu siliziumgebundenen Wasserstoff-Atomen zwischen 0,5:1 und 2:1 liegt.

In der erfindungsgemäßen, additionsvernetzenden Siliconharzzusammensetzung ist das Verhältnis von Si-Alkenyl zu Si-H bevorzugt von 0,5:1 bis 2:1; bevorzugt 0,6:1 bis 1,8:1, besonders bevorzugt 0,6:1 bis 1,6:1, insbesondere 0,7:1 bis 1,5:1.

Organopolysiloxane A) haben vorzugsweise ein Molekulargewicht Mw von mindestens 1000, bevorzugt mindestens 1300, besonders bevorzugt mindestens 1800, insbesondere von mindestens 2000 haben, wobei die Polydispersität höchstens 15, bevorzugt höchstens 12, besonders bevorzugt höchstens 9, insbesondere höchstens 6 ist.

Organopolysiloxane A) haben Viskositäten von mindestens 1500 mPas, bevorzugt mindestens 2000 mPas, insbesondere mindestens 2500 mPas. In einer weiteren bevorzugten Ausführungsform handelt es sich um hochviskose A) mit einer Viskosität von mindestens 8000 mPas, besonders bevorzugt mindestens 10000 mPas, insbesondere mindestens 12000 mPas. In einer ebenfalls bevorzugten Form handelt es sich bei A) um bei Raumtemperatur von 23°C nicht mehr fließfähige standfeste Massen mit noch klebriger Oberfläche oder um klebfreie Festkörper mit einer Glasübergangstemperatur von mehr als 25°C. Alle Angaben zur Viskosität sind bei 25°C und bei Normaldruck von 1013 mbar gültig.

Organische Gruppen R¹ bis R⁶ können lineare oder verzweigte Alkylreste mit bevorzugt 1 bis 10 Kohlenstoffatomen, bzw. Alkenylreste mit bevorzugt 2 bis 8 Kohlenstoffatomen, bzw. Arylreste mit bevorzugt 6 bis 8 Kohlenstoffatomen sein. Die vorgenannten können jeweils auch Heteroatome enthalten. Bei den Heteroatomen kann es sich beispielweise um Sauerstoff, Stickstoff, Silicium, Phosphor oder Halogen wie F, Cl, Br handeln.

Ausgewählte Beispiele für Alkylreste als Reste R¹ bis R⁶ sind der Methyl-, Ethyl-, n-Propyl-, iso-Propyl-, n-Butyl-, isoButyl-, tert.-Butyl-, n-Pentyl-, iso-Pentyl-, neo-Pentyl-, tert.-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste. Der Methyl- und Ethylreste -sind dabei die bevorzugten Alkylreste.

Ausgewählte Beispiele für Alkenylreste als Reste R¹ bis R⁶ sind der Vinylrest, der ggf. substituiert sein kann, der Allylrest, der Butenylrest, der Pentenylrest, der Hexenylrest, der Heptenylrest, der Octenylrest oder der Cyclohexenylrest. Der Vinylrest ist dabei der bevorzugte Alkenylrest.

Ausgewählte Beispiele für Arylreste als Reste R¹ bis R⁶ sind Phenylrest, Tolylreste, Xylylreste und Ethylphenylreste, und Aralkylreste, wie der Benzylrest und der ß-Phenylethylrest.

Das molare Verhältnis der siliziumgebundenen Alkenyl-Gruppen tragenden Wiederholungseinheiten zu den siliziumgebundene Wasserstoffatome tragenden Wiederholungseinheiten in A) beträgt mindestens 0,75 beträgt, vorzugsweise 0,8, besonders bevorzugt 0,9.

Der molare Anteil der mindestens einen Arylrest tragenden Siliziumatome zur Gesamtanzahl der Siliziumatome in A) beträgt mindestens 30%, bevorzugt mindestens 40%, insbesondere mindestens 50%.

Der molare Anteil der Alkylgruppen an der Gesamtzahl der siliziumgebundenen Reste in A) beträgt höchstens 70%, bevorzugt höchstens 65%, besonders bevorzugt höchstens 60%, insbesondere höchstens 55%.

Der molare Anteil der OH-Gruppen an der Gesamtzahl der siliziumgebundenen Reste beträgt in A) höchstens 3%, bevorzugt höchstens 2,5%, besonders bevorzugt höchstens 2,0% insbesondere höchstens 1,5%.

Der molare Anteil an Wasserstoff-Gruppen an der Gesamtzahl der siliziumgebundenen Reste beträgt in A) 0,1 - 45%, bevorzugt 1 - 42%, besonders bevorzugt 2 - 39%, insbesondere 2,5 - 36%. Die Bestimmung erfolgt mittels ²⁹Si-NMR-Spektroskopie.

Der molare Anteil an Vinylgruppen beträgt 2 - 45%, bevorzugt 4 - 42%, besonders bevorzugt 6 - 39%, insbesondere 8 - 36%. Die Bestimmung erfolgt mittels ²⁹Si-NMR-Spektroskopie.

Die Teileinheiten (R¹R²R³SiO_{1/2})_{M} gemäß der allgemeinen Formel (I) sind in A) höchstens zu 55 mol-% vorhanden, bevorzugt höchstens 50 mol-%, besonders bevorzugt höchstens 45 mol-%, insbesondere höchstens 40 mol-%. Die Reste R¹, R², R³ sind bevorzugt keine Aryl-Gruppe. Die Reste R¹R²R³ sind besonders bevorzugt H, kurzkettige Alkyl-, wie Methyl-, kurzkettige Alkenyl-, wie Vinyl-, sowie Methoxy. Besonders bevorzugt sind als Ausführungsformen der Erfindung: (CH₃)₃SiO_{1/2}, (CH₃)₂(CH₂=CH)SiO_{1/2,} (CH₃)₂(H)SiO_{1/2}.

Mindestens 5 mol-% der Teileinheiten von A) sind solche der Form (R⁴R⁵SiO_{2/2})_{D}, bevorzugt mindestens 8 mol-%, besonders bevorzugt mindestens 10 mol-%, insbesondere mindestens 12 mol-%, jedoch höchstens 65 mol-%, bevorzugt höchstens 60 mol-%, besonders bevorzugt höchstens 55 mol-%, insbesondere höchstens 50 mol-%. Die Teileinheiten (R⁴R⁵SiO_{2/2})_{D} in A) dienen insbesondere der Einstellung einer optimalen Balance zwischen Härte und Flexibilität nach Vernetzung.
Um dies zu erreichen tragen mindestens 6 mol% aller Teileinheiten (R⁴R⁵SiO_{2/2})_{D} keine Reste R⁴ und R⁵, die ein Wasserstoff-Atom oder ein Alkenylrest sind, und sie liegen gleichzeitig als Kettensegmente von 3 bis 200 aneinandergereihten Teileinheiten in A) vor. Es muss somit ein Mindestanteil von diesen Teileinheiten im Molekül A) frei von aktiven Gruppen sein, um nicht an der Hydrosilylierungsreaktion während der Aushärtung zum Formkörper teilnehmen zu können. Der Mindestanteil an allen Teileinheiten (R⁴R⁵SiO_{2/2})_{D} die keine Reste R⁴ und R⁵ haben, die ein Wasserstoff-Atom oder ein Alkenylrest sind, und gleichzeitig als Kettensegmente vorliegen, ist bevorzugt mindestens 9 mol-%, besonders bevorzugt mindestens 12 mol-%, insbesondere mindestens 15 mol-%, jedoch höchstens 65 mol-%, bevorzugt höchstens 60 mol-%, besonders bevorzugt höchstens 55 mol-%, insbesondere höchstens 50 mol-%. Diese Kettensegmente sind bevorzugt aneinandergereihte Teileinheiten von 3 bis 150, insbesondere 3 bis 100. Das bedeutet, dass sie aneinandergereiht und somit in ununterbrochener Abfolge vorliegen.

Als Reste R⁴R⁵ sind bevorzugt Alkyl- und Aryl-Reste. Insbesondere sind Methyl, Phenyl, bevorzugt.
Besonders bevorzugt sind als Ausführungsformen der Erfindung: (CH₃)₂SiO_{2/2}, (CH₃) (C₆H₅) SiO_{2/2}.
Sind ein hoher Brechungsindex oder besonders hohe Temperaturstabilität gewünscht, so sollen mindestens 50 mol-%, bevorzugt mindestens 55 mol-%, besonders bevorzugt mindestens 60 mol-%, insbesondere mindestens 65 mol-% der Kettensegmente mindestens einen Aryl-Rest tragen. In einer besonders bevorzugten Ausführungsform tragen mindestens 50 mol-%, bevorzugt mindestens 55 mol-%, besonders bevorzugt mindestens 60 mol-%, insbesondere mindestens 65 mol-% der Kettensegmente gleichzeitig einen Alkyl- und einen Aryl-Rest.

Diese Kettensegmente sind ausschlaggebend für die vorliegende Erfindung, da sie zu einer intramolekularen Flexibilisierung der Harzstruktur von A) führen, so dass ausgehärtete Formkörper eine mindestens so gute Flexibilität aufweisen, wie Formkörper aus komplexeren Zusammensetzungen, die zusätzliche, flexibilisierende Additive enthalten müssen, um die gleichen Eigenschaften zu erreichen.
Diese Kettensegmente werden somit nur zum Zwecke der Steuerung der mechanischen Eigenschaften von aus erfindungsgemäßen verzweigten Polyorganosiloxanen erhältlichen Formkörpern eingebracht und sind frei von additionsvernetzbaren Funktionen. Nur so ist gewährleistet, dass diese Kettensegmente nach der Vernetzung unverändert erhalten bleiben. Würden sie an der Vernetzungsreaktion teilnehmen, so würde dies zur Erhöhung des Verzweigungsgrades beitragen und ihre flexibilisierende Wirkung ginge teilweise oder sogar ganz verloren. Daher ist es wichtig, dass die flexibilisierenden Einheiten auf jeden Fall so gestaltet sind, dass sie keine an der späteren Additionsvernetzung partizipierenden Gruppen, also insbesondere siliziumgebundene Alkenyl- oder Wasserstoffreste enthalten. Überraschend ist, dass bereits eine Länge der Kettensegmente aus mindestens 3 Teileinheiten ausreichend ist, um eine merkliche intramolekulare Flexibilisierung zu erzielen, wenn eine gewisse Mindestmenge solcher Kettensegmente in der gesamten Molekülstruktur eingebunden ist.

Die Teileinheiten (R⁶SiO_{3/2})_{T} gemäß der allgemeinen Formel (I) sind in A) mindestens zu 10 mol-% vorhanden, besonders bevorzugt mindestens 20 mol-%, insbesondere mindestens 25 mol-%. Bevorzugt ist R⁶ eine Aryl-Gruppe und kein Wasserstoff-Atom und keine Alkenyl-Gruppe. Als Aryl-Gruppe R⁶ ist der Phenylrest besonders bevorzugt. Von dieser Teileinheit ist in A) bevorzugt mindestens 1 vorhanden, mit einem Arylrest als R⁶, bevorzugt Phenylrest.

Die Teileinheiten (SiO_{4/2})_{Q} gemäß der allgemeinen Formel (I) sind in A) höchstens zu 20 mol-% vorhanden, besonders bevorzugt höchstens zu 15 mol-%, insbesondere bevorzugt sind keine solcher Teileinheiten in A) vorhanden.
Die Summe aus allen 4 vorgenannten Teileinheiten ergibt stets 100 mol-%.

Im Stand der Technik sind verschiedene Verfahren bekannt mit deren Hilfe A) aus kommerziell erhältlichen Edukten hergestellt werden kann wie Alkoxysilanen, Chlorsilanen, bzw. Kombinationen derselben und des Weiteren unter Verwendung kurzkettiger Organosiloxane. Diese Verfahren umfassen eine Auswahl und geeignete Kombination der Reaktionen Hydrolyse, Kondensation und Äquilibrierung. Mögliche Herstellverfahren sind diskontinuierliche Rührwerksverfahren, kontinuierliche Rührwerkskaskadenverfahren, quasikontinuierliche Verfahren durch Zusammenschaltungen von kontinuierlichen mit diskontinuierlichen Verfahrensschritten, kontinuierliche Verfahren, wie beispielsweise solche in Loop Reaktoren oder Kolonnenreaktoren, die durch Verschaltungen mehrerer Anlagen ggf. als Doppelloop oder Doppelkolonnenverfahren ausgelegt werden können. Ebenso sind Kombinationen aus einem Loopreaktor und einem Kolonnenreaktor denkbar.

Ein Herstellverfahren setzt Alkoxysilanen, gegebenenfalls im Gemisch mit kurzkettigen Organosiloxanen, in einem ersten Reaktionsschritt über eine saure Hydrolyse um, und Kondensiert dann gegebenenfalls stufenweise oder kontinuierlich. Die Reaktionsmischung wird entweder durch Neutralisieren der Säure oder durch neutral-Waschen mit vollentsalztem Wasser neutralisiert und anschließend durch eine geeignete Kombination der Schritte Destillation und Filtration zur gewünschten Reinheit isoliert.

Weitere geeignete Herstellverfahren sind beispielsweise in den folgenden Schriften offenbart: DE 102005003899A1, DE102005047394, DE102005047395A1, DE102009045930A1, DE10242418A1 und DE102005003898A1.

Die Komponente B) kann zusätzlich eingesetzt werden, falls eine weitere Einstellung der Verarbeitungseigenschaften notwendig ist. B) ist ein Si-H-Koppler, welcher pro Molekül mindestens 2 Si-H-Bindungen enthält und ausgewählt wird aus den folgenden Gruppen:
a) Organowasserstoffsilane der allgemeinen Formel (II)

   R⁷_{g}(H)ₕSi-R⁸-Si(H)ⱼR⁹ⱼ (II)

   wobei
   -R⁷ und R⁹ unabhängig voneinander, einwertige, gegebenenfalls substituierte Kohlenwasserstoffreste, die durch Heteroatome unterbrochen sein können, wobei R⁷ und R⁹ keine Alkenyl-Gruppe, keine OH-Gruppe und kein Wasserstoffatom,
   -H ein Wasserstoffatom bedeuten,
   -R⁸ eine Cl bis C36 Hydrocarbylen-Gruppe, die durch Heteroatome unterbrochen sein können, und solche Reste R⁸ stets mit einer Kohlenstoff-Siliziumbindung an die Siliziumatome gebunden vorliegen,
   oder ein Sauerstoffatom,
   bedeutet,
   - g und j die Werte 0, 1, 2 und 3 haben können,
   - h und i die Wert 1, 2 und 3 haben können,
   und g+h=3 sowie i+j=3 jeweils erfüllt sind,
b) Organowasserstoffsiloxane der Formel (III)

   [R¹⁰ₖ(H)ₗSiO_{1/2}]₄Si (III)

   wobei
   - R¹⁰ unabhängig voneinander einwertige, gegebenenfalls substituierte Kohlenwasserstoffreste bedeuten, die durch Heteroatome unterbrochen sein können, wobei R¹⁰ keinen Alkenyl-Gruppe, keine OH-Gruppe und kein Wasserstoffatom bedeutet,
   - H ein Wasserstoffatom
   bedeutet,
   - k und 1 die Werte 0, 1, 2 und 3 haben können, und k+1=3 erfüllt ist,
c) Polyorganohydrogensiloxane aus Wiederholungseinheiten der Formel (V),

   H_{d}R⁷ₑSi(OR⁹)_{f}O_{(4-d-e-f)/2} (V),

   wobei
   H ein Wasserstoffatom bedeutet,
   R⁷ und R⁹ die oben angegebene Bedeutung haben, f 0 und 1 sind, wobei f in höchstens 10% der Einheiten der Formel (V) 1 bedeutet und ansonsten den Wert 0 hat, d+e stets > 0 ist und in mindestens 2 Einheiten der Formel (V) den Wert 3 hat, wobei in diesen beiden Einheiten bevorzugt d = 1 und e = 2 ist und in allen anderen Einheiten vorzugsweise gilt d = 0 und e = 2.
      c) besteht aus mindestens 3 Wiederholungseinheiten der Formel (V).
      Mindestens 10 mol-%, bevorzugt mindestens 20 mol-%, besonders bevorzugt mindestens 25 mol-%, insbesondere mindestens 30 mol-% von c) enthalten ein siliziumgebundenes Wasserstoffatom enthalten.
      Lineare Polyorganohydrogensiloxane c) haben mindestens zwei Wiederholungseinheiten der Formel (V) die ein Wasserstoffatom und gleichzeitig einen Alkyl- oder Arylrest tragen und mindestens eine, vorzugsweise alle weiteren Wiederholungseinheiten tragen Alkyl- und/oder Arylreste.

Auf 100 Teile A) werden höchstens 20 Teile Si-H-Koppler B) eingesetzt, bevorzugt höchstens 17 Teile, besonders bevorzugt höchstens 14 Teile, insbesondere höchstens 10 Teile.

Reste R⁷, R⁹, R¹⁰ des Si-H-Kopplers B) sind lineare oder verzweigte Alkylreste mit bevorzugt 1 bis 10 Kohlenstoffatomen, sie können jeweils auch Heteroatome enthalten. Bei den Heteroatomen kann es sich beispielweise um Sauerstoff, Stickstoff, Silicium, Phosphor oder Halogen wie F, Cl, Br handeln. Beispiele für Alkylreste als R⁷, R⁹, R¹⁰ entsprechen denen unter R¹ bis R⁶ genannten. Der am meisten bevorzugte Rest für die Reste R⁷, R⁹ und R¹⁰ ist der Methylrest.

Bei den Resten R⁸ handelt es sich um substituierte oder nicht substituierte Hydrocarbylenreste, also um zweiwertige und gegebenenfalls Heteroatome enthaltende Kohlenwasserstoffreste.

Beispiele für bevorzugte Alkylen- und Arylenreste Reste R⁸ sind der Methylenrest -CH₂-, der Ethylenrest -CH₂-CH₂-, der Propylenrest -(CH₂)₃-, der Butylenrest -(CH₂)₄-, der Pentylenrest - (CH₂)₅-, der Hexylenrest -(CH₂)₆-, der Octylenrest - (CH₂)₈-, sowie die zugehörigen isomeren Alkylenreste, Cycloalkylenreste wie der Cyclohexylenrest und substituierte Cyclohexylenreste, Arylenreste wie der ortho-, meta- oder para- Phenylenrest-(C₆H₄)-, wobei der para-Phenylenrest besonders bevorzugt ist und Arylenreste der Form 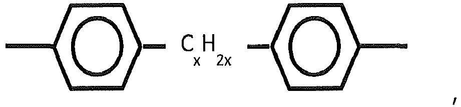 wobei x eine ganze Zahl im Wert von 0 bis 8 bedeutet.
Darüber hinaus kann der Rest R⁸ ein Sauerstoffatom bedeuten. Insbesondere bevorzugt ist der para-Phenylenrest für R⁸.

Typische Beispiele für Si-H-Koppler (B) gemäß Formel (III) sind folgende Organosiloxane:

[(CH₃)₂(H)SiO_{1/2}]₄Si

[(CH₃CH₂)₂(H)SiO_{1/2}]₄Si

[(CH₃)₂(H)SiO_{1/2}]₂[(CH₃)₃SiO_{1/2}]₂Si

[(CH₃CH₂)₂(H)SiO_{1/2}]₂[(CH₃)₃SiO_{1/2}]₂Si

[(CH₃)₂(H)SiO_{1/2}]₂[(CH₃)(CH₃CH₂)₂SiO_{1/2}]₂Si

Die Si-H-Koppler B) gemäß Formel (III) wirken wie ein Punktvernetzer und bringen mehr Härte in den ausgehärteten Molekülverband ein, als die Si-H-Koppler B) gemäß Formel (II), insbesondere, wenn sie 4 siliziumgebundene Wasserstoffatome enthalten. Insbesondere Si-H-Koppler B) gemäß Formel (III) mit der sehr hohen Si-H-Funktionsdichte von 4 Si-H-Gruppen je Organosiloxanmolekül eignen sich sehr gut, um hochmolekulare A) mit geringer Vinylgruppenzahl zu harten Formkörpern zu vernetzen. Aus diesem Grund sind die Si-H-Koppler B) gemäß Formel (III) insbesondere für solche Anwendungsfälle bevorzugt.

Als geeignete Katalysatoren C), können alle Verbindungen eingesetzt werden, die die Anlagerung von siliziumgebundenem Wasserstoff an aliphatische Doppelbindungen fördern. Es handelt sich dabei vorzugsweise um ein Metall aus der Gruppe der Platinmetalle oder um eine Verbindung oder einen Komplex aus der Gruppe der Platinmetalle. Beispiele für solche Katalysatoren sind metallisches und feinverteiltes Platin, das sich auf Trägern, wie Siliziumdioxid, Aluminiumdioxid oder Aktivkohle befinden kann, Verbindungen oder Komplexe von Platin, wie Platinhalogenide, z.B. PtCl₄, H₂PtCl₆x6H₂O, Na₂PtCl₄x4H₂O, Platin Olefinkomplexe, Platin Alkoholkomplexe, Platin Alkoholatkomplexe, Platin Ether Komplexe, Platin Aldehyd Komplexe, Platin Keton Komplexe, einschließlich Umsetzungsprodukten aus H₂PtCl₆x6H₂O und Cyclohexanon, Platin Vinyl Siloxankomplexe, wie Platin-1,3-divinyl-1,1,3,3-tetramethyldisiloxan Komplexe mit oder ohne Gehalt an nachweisbarem anorganisch gebundenem Halogen, Bis-(gamma-picolin)-platindichlorid, Trimethylendipyridinplatindichlorid, Dicyclopentadienplatindichlorid, Dimethylsulfoxidethylenplatin(II)-dichlorid, Cyclooctadien-Platindichlorid, Norbornadienplatindichlorid, Gamma-picolin-Platindichlorid, Cyclopentadien-Platindichlorid, sowie Umsetzungsprodukte von Platintetrachlorid mit Olefin und primärem Amin oder sekundärem Amin oder primärem und sekundärem Amin, wie das Umsetzungsprodukt aus in 1-Octen gelöstem Platintetrachlorid mit sec.-Butylamin oder Ammoniumplatinkomplex. Der Katalysator wird in den erfindungsgemäßen Zubereitungen vorzugsweise in Mengen von 5 bis 2000 Gew.-ppm (Gewichtsteilen je Million Gewichtsteilen), bevorzugt in Mengen von 10 bis 1000 Gew.-ppm, insbesondere in Mengen von 15 bis 500 Gew.-ppm, jeweils berechnet als elementares Platin und bezogen auf das Gesamtgewicht der Polyorganosiloxane A), B) und der Organosiloxane und / oder Organosilane C) eingesetzt.

Bevorzugt wird als Katalysator der in der Literatur lange bekannte Karstedt Katalysator (US 3 775 452) eingesetzt, dessen aktive Spezies gemäß Comprehensive Handbook of Hydrosilylation Herausgeber Bogdan Marciniec, Pergamon Press 1992 Pt₂{[(CH₂=CH)(CH₃)₂Si]₂O}₃ ist.

Die erfindungsgemäße additionsvernetzende Siliconharzzusammensetzung kann als weiteren optionalen Bestandteil mindestens ein Flexipolymer D) der allgemeinen Formel (IV) enthalten,

(R¹¹_{w}R¹²_{x*}SiO_{1/2})_{M*}(R¹¹_{y}R¹²_{z}SiO_{2/2})_{D*}(R¹³SiO_{3/2})_{T*} (IV),

wobei
- R¹¹ und R¹² und R¹³ unabhängig voneinander, gegebenenfalls substituierte Kohlenwasserstoffreste, die durch Heteroatome unterbrochen sein können, und kein Wasserstoff-Atom;
- w und x* jeweils eine Zahl 0, 1, 2 oder 3, mit w+x* = 3;
- y und z jeweils eine Zahl 0, 1, 2 oder 3, mit y+z = 2;
- M*, D*, und T* eine Zahl von 0 bis <1, mit M*+D*+T*=1 bedeuten,
mit der Maßgabe, dass pro Molekül D)
- mindestens zwei Alkenyl-Gruppen als R¹¹, und
- mindestens eine Aryl-Gruppe als R¹² oder R¹³
enthalten ist.

Flexipolymer D) kann zur weiteren Einstellung der mechanischen Eigenschaften des ausgehärteten Formkörpers dienen. Für D) ist eine geringe Vernetzung bevorzugt und somit T* möglichst klein zu halten. Besonders bevorzugt handelt es sich um lineare Polyorganosiloxane, somit ist T*=0 bevorzugt.

Beispiele für Reste R¹¹, R¹² und R¹³ sind die gleichen wie die bereits für R¹ genannten, mit der Ausnahme dass sie kein Wasserstoff-Atom sein können.

R¹¹ bedeutet bevorzugt einen Alkenyl-, besonders bevorzugt einen Vinylrest. Reste R¹¹ können sowohl terminal in D) gebunden sein, als auch kettenständig, wobei es bevorzugt ist, dass die Reste R¹¹ terminal stehen und besonders bevorzugt nur terminal gebundene Reste R¹¹ in D) vorhanden sind. In einer besonders bevorzugten Ausführungsform der Erfindung besitzt D) zwei terminal gebundene Reste R¹¹ wobei je einer der beiden Reste R¹¹ an je einem terminalen Siliziumatom gebunden ist.

Bevorzugte Reste R¹² sind Alkyl- und Arylreste. Es ist besonders bevorzugt, dass die Reste R¹² Methyl-, Ethyl- oder Phenylreste sind, insbesondere Methyl- und Phenylreste. Es ist besonders bevorzugt, dass von zwei Resten R¹², die am gleichen Siliziumatome gebunden vorliegen, nur höchstens einer einen Phenylrest bedeutet und der andere einen Alkylrest, vorzugsweise einen Methylrest. Zwei Reste R¹², die am gleichen Siliziumatom gebunden sind, können zwei gleich oder verschiedene Alkylreste bedeuten, wobei es besonders bevorzugt ist, dass es sich im Falle von zwei Alkylresten um Methylreste handelt.

Es ist bevorzugt, dass die Reste R¹³ Alkyl- oder Arylreste bedeuten, wobei Arylreste besonders bevorzugt sind, insbesondere der Phenylrest.

D) besteht aus mindestens 3 Si-Wiederholungseinheiten, vorzugsweise mindestens 5 Si-Wiederholungseinheiten, besonders bevorzugt mindestens 8, insbesondere mindestens 10 Si-Wiederholungseinheiten gemäß der allgemeinen Formel (IV).

Beispiele für geeignete Flexipolymere D) gemäß der allgemeine Formel (IV) sind nachfolgend angegeben, wobei die Auflistung nur beispielhaft für die Erfindung und nicht beschränkend zu verstehen ist:

T^{Ph}₅D^{Ph}₇₄D^{Vi}₄D₆M^{Vi}₂M₇

M^{Vi}₂D₂₁D^{Ph}₆

M₂M^{Vi}₂D₁₆T^{Ph}₂

M^{Vi}₂D^{Ph}₂

M^{Vi}₂D^{Ph}₃₄D₇

M^{Vi}₂D₁₃D^{Ph}₄₅

Dabei bedeuten

T^{Ph} = (C₆H₅)SiO_{3/2}

D = (CH₃)₂SiO_{2/2}

D^{Ph} = (CH₃)(C₆H₅) SiO_{2/2}

D^{Vi} = (CH₃)(CH₂=CH) SiO_{2/2}

M = (CH₃)₃SiO_{1/2}

M^{Vi} = (CH₃)₂(CH₂=CH)SiO_{1/2}

Die Indizes geben an, wie häufig die jeweilige Einheit in dem Polyorganosiloxan vorhanden ist.

Die linearen Flexipolymere D) dienen der Flexibilisierung in der erfindungsgemäßen Siliconharzzusammensetzung. Sie reagieren infolge ihrer Alkenylgruppen R¹¹, mit Si-H-Gruppen der Organopolysiloxane A) und des Si-H-Kopplers B). Auf diese Art und Weise werden harte Harzmoleküle mit flexibilisierenden Kettensegmenten verbrückt. D) kann in der erfindungsgemäßen Siliconharzzusammensetzung neben der Flexibilisierung, auch zur Viskositätseinstellung verwendet werden, wobei dies sowohl zu einer Erhöhung als auch einer Reduzierung der Viskosität führen kann. Außerdem kann es für eine katalysierte Zubereitung vorteilhaft sein ein Zweikomponentensystem zu formulieren, in dem eine Komponente den Katalysator enthält, um einen unerwünscht frühzeitigen Start der Härtungsreaktion, z.B. während der Lagerung zu unterdrücken. Die Verwendung von D) erübrigt sich, wenn sowohl die Flexibilität, als auch die Viskosität die gewünschte Eigenschaft erfüllen. Ist D) enthalten, so werden bezogen auf 100 Teile A) 5 bis 200 Teile D) eingesetzt, bevorzugt 5 - 150 Teile, besonders bevorzugt 5 - 100 Teile, insbesondere 10 - 80 Teile.

Die erfindungsgemäße additionsvernetzende Siliconharzzusammensetzung kann weitere Bestandteile E) enthalten die dem Fachmann bekannt sind. Typische Vertreter sind Inhibitoren, verstärkende und nicht verstärkende Füllstoffe, Weichmacher, Haftvermittler, lösliche Farbstoffe, anorganische und organische Pigmente, Fluoreszenzfarbstoffe, Lösemittel, Fungicide, Duftstoffe, Dispergierhilfsmittel, rheologische Additive, Korrosionsinhibitoren, Lichtschutzmittel, Hitzestabilisatoren, flammabweisend machende Mittel, Mittel zur Beeinflussung der elektrischen Eigenschaften und Mittel zur Verbesserung der Wärmeleitfähigkeit.

Weiterer Gegenstand der Erfindung ist ein Verfahren zur Herstellung der erfindungsgemäßen, additionsvernetzenden Siliconharzzusammensetzungen durch Vermischen aller Komponenten A) und C) und falls gewünscht weiterer optionaler Bestandteile B) oder/und D) oder/und E).

Ein weiterer Gegenstand der Erfindung ist die Verwendung der erfindungsgemäßen Silikonharzzusammensetzungen als Gussmassen zur Herstellung von Formkörpern, oder Verkapselungen in elektrischen und elektronischen Anwendungen wie beispielsweise LEDs. Dabei erfolgt nach dem Befüllen der gewünschten Formen das anschließende Aushärten bei erhöhter Temperatur. Die Vernetzung der erfindungsgemäßen Silikonharzzusammensetzungen erfolgt vorzugsweise bei 70 bis 250°C, bevorzugt bei 100 bis 200°C. Als Energiequellen für die Vernetzung durch Erwärmen werden vorzugsweise Öfen, z.B. Umlufttrockenschränke, Heizkanäle, beheizte Walzen, beheizte Platten oder Wärmestrahlen des Infrarotbereiches verwendet.

Die Vernetzungszeiten betragen vorzugsweise 0,5 bis 10 Stunden, bevorzugt 1 bis 6 Stunden.

So hergestellte Formkörper sind - sofern keine weiteren Zusatzstoffe zugemischt wurden - glasklar und haben einen Brechungsindex von mindestens 1,40 bevorzugt mindestens 1,60.

Die so hergestellten Formkörper weisen nach vollständiger Aushärtung ohne weitere Zusatzstoffe, wie z.B. Füllstoffe oder Weichmacher, eine Shore D-Härte von mindestens 5, bevorzugt im Bereich von 5 bis 65, insbesondere im Bereich von 8 bis 60 auf.

Die Shore D-Härte wird nach DIN (Deutsche Industrie Norm) 53505 (bzw. ASTM D2240 oder ISO 868) bestimmt. In dieser Norm wird auch die Shore D-Skala der Härte nach Shore A gegenübergestellt. Diese hohen Härten sind ein wesentliches Kriterium der Erfindung da die Formkörper bei mechanischer Belastung kein Verkratzen erlauben und somit auch die Schmutzablagerung verringern so dass über einen langen Zeitraum eine hohe Lichtausbeute gewährleistet ist. Aufgrund ihrer Temperatur- und UV-Beständigkeit zeigen die Formkörper auch bei HB-LEDs (High-Brightness-LEDs) sowie LEDs, die Licht kurzer Wellenlänge (380 - 450 nm) bzw. weißes Licht emittieren, auch nach 40 000 Stunden Betriebsdauer keinen Abfall der Lichtdurchlässigkeit. Für sämtliche Bauformen von LEDs, die Chipabdeckung erfordern, können die erfindungsgemäßen Massen verwendet werden.

Neben der Anwendung als Vergussmassen zur Herstellung von Formkörpern können die erfindungsgemäßen Silikonharzzusammensetzungen beispielsweise auch für Beschichtungen und Imprägnierungen verwendet werden oder auch als Additive in anderen Zusammensetzungen Einsatz finden. Da das modulare System gleichwohl sehr hohe als auch sehr niedrige Viskositäten einzustellen erlaubt, sind weiterhin Verwendungen als Imprägnierharz, z.B. von elektrischen Isoliersystemen in Motoren, Transformatoren und Kabeln, im Verbund mit anderen Materialien, z.B. Glasgewebe, Papier, Glas-Glimmer-Bänder, etc. möglich.

Im vorliegenden Text werden Stoffe durch Angabe von Daten charakterisiert, die mittels instrumenteller Analytik erhalten werden. Die zugrundeliegenden Messungen werden entweder öffentlich zugänglichen Normen folgend durchgeführt oder nach speziell entwickelten Verfahren ermittelt. Um die Klarheit der mitgeteilten Lehre zu gewährleisten, sind die verwendeten Methoden hier angegeben:

### Viskosität:

Die Viskositäten werden, wenn nicht anders angegeben, durch rotationsviskosimetrische Messung gemäß DIN EN ISO 3219 bestimmt. Falls nicht anders angegeben, gelten alle Viskositätsangaben bei 25°C und Normaldruck von 1013 mbar.

### Brechungsindex:

Die Brechungsindices werden im Wellenlängenbereich des sichtbaren Lichtes bestimmt, falls nicht anders angegeben bei 589 nm bei 25°C und Normaldruck von 1013 mbar gemäß der Norm DIN 51423.

### Transmission:

Die Transmission wird durch UV VIS Spektroskopie bestimmt. Ein geeignetes Gerät ist beispielsweise das Analytik Jena Specord 200.
Die verwendeten Messparameter sind Bereich: 190 - 1100 nm Schrittweite: 0,2 nm, Integrationszeit: 0,04 s, Messmodus: Schrittbetrieb. Als erstes erfolgt die Referenzmessung (Background). Eine Quarzplatte befestigt an einem Probenhalter (Dimension der Quarzplatten: HxB ca. 6 x 7 cm, Dicke ca 2,3 mm) wird in den Probenstrahlengang gegeben und gegen Luft gemessen. Danach erfolgt die Probenmessung. Eine am Probenhalter befestigte Quarzplatte mit aufgetragener Probe - Schichtdicke aufgetragene Probe ca. 1 mm - wird in den Probenstrahlengang gegeben und gegen Luft gemessen. Interne Verrechnung gegen Backgroundspektrum liefert das Transmissionsspektrum der Probe.

### Molekülzusammensetzungen:

Die Molekülzusammensetzungen werden mittels Kernresonanzspektroskopie bestimmt (zu Begrifflichkeiten siehe ASTM E386: Hochauflösende magnetische Kernresonanzspektroskopie (NMR): Begriffe und Symbole), wobei der ¹H-Kern und der ²⁹Si-Kern vermessen wird.

### Beschreibung -¹H-NMR Messung

Solvent: CDCl₃, 99,8%D
Probenkonzentration: ca. 50 mg / 1 ml CDCl₃ in 5 mm NMR-Röhrchen

Messung ohne Zugabe von TMS, Spektrenreferenzierung von Rest-CHCl₃ in CDCl₃ auf 7,24 ppm
Spektrometer: Bruker Avance I 500 oder Bruker Avance HD 500
Probenkopf: 5 mm BBO-Probenkopf oder SMART-Probenkopf (Fa. Bruker)

### Meßparameter:

Pulprog = zg30
TD = 64k
NS = 64 bzw. 128 (abhängig von der Empfindlichkeit des Probenkopfes)
SW = 20,6 ppm
AQ = 3,17 s
D1 = 5 s
SF01 = 500,13 MHz
O1 = 6,175 ppm

### Processing-Parameter:

SI = 32k
WDW = EM
LB = 0,3 Hz

Je nach verwendetem Spektrometertyp sind evtl. individuelle Anpassungen der Messparameter erforderlich.
Beschreibung ²⁹Si-NMR Messung
Solvent: C₆D₆ 99,8%d/CCl4 1:1 v/v mit 1Gew% Cr(acac)3 als Relaxationsreagenz
Probenkonzentration: ca. 2 g / 1,5 ml Solvent in 10 mm NMR-Röhrchen
Spektrometer: Bruker Avance 300
Probenkopf: 10 mm 1H/13C/15N/29Si glasfreier QNP-Probenkopf (Fa. Bruker)

### Messparameter:

Pulprog = zgig60
TD = 64k
NS = 1024 (abhängig von der Empfindlichkeit des Probenkopfes)
SW = 200 ppm
AQ = 2,75 s
D1 = 4 s
SFO1 = 300,13 MHz
O1 = -50 ppm

### Processing-Parameter:

SI = 64k
WDW = EM
LB = 0,3 Hz

Je nach verwendetem Spektrometertyp sind evtl. individuelle Anpassungen der Messparameter erforderlich.

### Molekulargewichtsverteilungen:

Molekulargewichtsverteilungen werden als Gewichtsmittel Mw und als Zahlenmittel Mn bestimmt, wobei die Methode der Gelpermeationschromatographie (GPC bzw. Size Exclusion Chromatographie (SEC)) Anwendung findet mit Polystyrol Standard und Brechnungsindexdetektor (RI-Detektor). Wo nicht anders ausgewiesen wird THF als Eluent verwendet und DIN 55672-1 angewendet. Die Polydispersität ist der Quotient Mw/Mn.

### Glasübergangstemperaturen:

Die Glasübergangstemperatur wird nach Dynamischer Differenzkalorimetrie (Differential Scanning Calorimetry, DSC) nach DIN 53765, gelochter Tiegel, Aufheizrate 10 K/min bestimmt.

### Beispiele:

Im Folgenden werden Beispiele für die erfindungsgemäßen Zubereitungen und ihre Herstellung gegeben.
Alle Prozentangaben beziehen sich auf das Gewicht. Falls nicht anders angegeben werden alle Manipulationen bei Raumtemperatur von etwa 23°C und unter Normaldruck (1,013 bar) ausgeführt. Bei den Apparaten handelt es sich um handelsübliche Laborgeräte wie sie von zahlreichen Geräteherstellern käuflich angeboten werden.
Ph bedeutet einen Phenylrest = C₆H₅-Me bedeutet einen Methylrest = CH₃-.
Me₂ bedeutet entsprechend zwei Methylreste.

Eine wesentliche Eigenschaft der erfindungsgemäßen Zubereitungen, ist dass sie über mit sich selbst vernetzbare, verzweigte Polyorganosiloxankomponenten verfügen. Die Synthesen solcher Produkte werden nachfolgend beschrieben:

### Gegenbeispiel 1: nicht erfindungsgemäß

In ein 60 1 Glasrührwerk werden 16116 g Wasser, 12240 g Toluol und 5436 g Ethylacetat eingewogen und gemischt. Zu dieser Vorlage wird eine Mischung aus 1947,3 g Methyldichlorsilan (CH₃)Si(H)Cl₂ (115 g/mol => Einwaage 16,93 mol), 7770 g Phenyltrichlorsilan PhSiCl₃ (211,5 g/mol => Einwaage 36,74 mol) und 2061 g Vinyldimethylchlorsilan (CH₂=CH)Me₂SiCl (120,5 g/mol => Einwaage 17,10 mol) innerhalb von 3 Stunden gleichmäßig zugegeben. Die Exothermie der Reaktion führt zu einer Temperaturerhöhung von nicht mehr als 47°C. Man lässt 30 Minuten nachrühren und danach 30 Minuten ohne Rühren absetzen, damit sich die Phasen trennen können. 24 kg salzsaure Wasserphase werden anschließend abgetrennt. Man gibt zur organischen Phase 12 kg vollentsalztes Wasser (VE-Wasser) zu, rührt 30 Minuten und lässt danach 30 Minuten ohne Rühren stehen, so dass sich die Phasen trennen können. Die Wasserphase wird abgetrennt und die organische Phase in gleicher Weise noch dreimal mit jeweils 12 kg VE-Wasser gewaschen. Im Anschluss an die letzte Waschung wird die organische Phase auf 80°C erhitzt, wobei die Apparatur auf 150 mbar Innendruck evakuiert wird. Man destilliert alle bei 80°C und dem angegebenen Unterdruck flüchtigen Bestandteile ab und erhält 8 kg Rohprodukt, die anschließend bei 160°C und 20 mbar Unterdruck solange weiter ausdestilliert werden, bis keine unter diesen Bedingungen flüchtige Bestandteile mehr enthalten sind. Man erhält 6 kg Produkt. Das erhaltene Produkt weißt eine Viskosität von 5150 mPas bei 25°C und Normaldruck von 1013 mbar auf. Der Restlösemittelgehalt ist gemäß ¹H-NMR: Toluol 0,06 Gew.-%. Der Gesamtchloridgehalt beträgt 8mg/kg. Die Farbzahl nach APHA beträgt 14, die Trübung nach Sigrist 2,55 ppm. Durch Size Exclusion Chromatographie (SEC) wird in THF als Eluent Mw = 2600 g/mol und Mn = 1500 g/mol bestimmt. Das Produkt weißt gemäß ²⁹Si-NMR Spektrum folgende molare Zusammensetzung auf:
(CH₂=CH)Me₂SiO_{1/2}: 21,6 %
Me(H)SiO_{2/2}: 24,3 %
Ph(OR)₂SiO_{1/2}: 0,4 %
Ph(OR)SiO_{2/2}: 17,5 %
PhSiO_{3/2}: 36,2 %
wobei R hier hauptsächlich für Ethyl steht, daneben auch für Wasserstoff.
Der Silanolgehalt kann wegen Signalüberlagerungen nur ungefähr geschätzt werden und beträgt gemäß Schätzung aus dem ¹H-NMR-Spektrum ungefähr 6500 ppm. Der Gehalt an Vinylgruppen beträgt gemäß ¹H-NMR 1,99 mmol/g, der Gehalt an siliziumgebundenem Wasserstoff 2,23 mmol/g.

**Beispiel 2: erfindungsgemäß** In ein 60 1 Glasrührwerk werden als Vorlage 16116 g Wasser, 12240 g Toluol, 5436 g Ethylacetat und 3108 g eines kurzkettigen alpha omega silanolfunktionellen Phenylmethylöls eingelegt, das die durchschnittliche Zusammensetzung hat: HO-Si(Me)(Ph) [O-Si(Me)(Ph)]₄OSi(Me) (Ph)OH, das also insgesamt 6 Siliziumwiederholungseinheiten umfasst, von denen jede mit einer Phenyl und einer Methylgruppe substituiert ist und von denen die beiden terminalen Siliziumatome jeweils eine Hydroxylfunktion tragen und das ein mittleres Molekulargewicht von Mw = 800 g/mol bei Mn = 700 g/mol hat, und eine Viskosität von 503 mPas bei 25°C und Normaldruck von 1013 mbar aufweist.

7770 g Phenyltrichlorsilan (211,5 g/mol => Einwaage 36,7 mol), 1800 g Vinyldimethylchlorsilan (120,5 g/mol => Einwaage 14,9 mol) und 1822,5 g Methyldichlorsilan (115 g/mol => Einwaage 15,8 mol) werden miteinander gemischt und innerhalb von 5 Stunden zur Vorlage zudosiert. Die Temperatur steigt dabei von 25,7°C auf 48,7°C. Man rührt nach beendeter Zugabe 45 Minuten nach, erhitzt anschließend für 1 Stunde auf Rückfluss (Sumpftemperatur 83°C) und stellt den Rührer dann ab. Nach 45 Minuten Phasentrennung wird die Wasserphase abgetrennt.
Zum Neutralwaschen werden 12 kg VE-Wasser zur organischen Phase zugegeben, 30 Minuten gerührt und 30 Minuten Phasen trennen lassen. Die Wasserphase wird abgetrennt. Dieser Waschvorgang wird insgesamt dreimal in gleicher Weise ausgeführt, bis der Rest HCl-Gehalt in der organischen Phase 3 ppm beträgt.
Man destilliert anschließend bei Normaldruck bis zu einer Rührguttemperatur von 124°C aus, wobei 9543 g Destillat und 14125 g Sumpfrückstand erhalten werden.
Vom Rückstand wird eine Probe von 1383,5 g genommen, die am Rotationsverdampfer bei einer Ölbadtemperatur von 160°C und einem Unterdruck von 20 mbar 1 Stunde ausdestilliert wird. Man erhält 962,1 g einer 69,6 Gew.-%igen Produktlösung, die heiß über eine Seitz K 100 Filterplatte mit Seitz Filterhilfe FF filtriert wird. Das erhaltene Filtrat ist klar und farblos. Es weist eine Brookfield Viskosität von 2870 mPas auf.

Das Produkt weißt laut SEC (Eluent THF) ein Molekulargewicht von Mw = 2400 g/mol und Mn = 1300 g/mol auf.
Der Silanolgehalt ist im ¹H-NMR aufgrund von Signalüberlagerungen nur ungefähr und beträgt etwa 10052 ppm. Der Vinylgehalt ist 1,30 mmol/g, der Gehalt an siliziumgebundenem Wasserstoff 1,44 mmol/g.
Nach ²⁹Si-NMR ist die molare Zusammensetzung:
(CH₂=CH)Me₂SiO_{1/2}: 15,2 %
Me(H)SiO_{2/2}: 15,4 %
Ph(Me)SiO_{2/2}: 27,3 % (schließt Ph(Me)(RO)SiO_{1/2} mit ein)
Ph(OR)₂SiO_{1/2}: 0,4 %
Ph(OR)SiO_{2/2}: 15,5 %
PhSiO_{3/2}: 26,2 %
wobei R hier hauptsächlich für Ethyl steht, daneben auch für Wasserstoff.

**Beispiel 3: erfindungsgemäß** In einen 4 1 4-Halsglasrundkolben mit Auslauf werden 135,0 g Methyldichlorsilan (CH₃)Si(H)Cl₂ (115 g/mol => Einwaage 1,17 mol), 518,0 g Phenyltrichlorsilan PhSiCl₃ (211,5 g/mol => Einwaage 2,45 mol) und 133,4 g Vinyldimethylchlorsilan (CH₂=CH)Me₂SiCl (120,5 g/mol => Einwaage 1,11 mol) zusammen mit 816 g Toluol eingewogen und gemischt.

Zu dieser Vorlage werden 185 g Ethanol innerhalb von 40 Minuten gleichmäßig zudosiert, wobei die Temperatur der Reaktionsmischung auf 16°C absinkt. Man rührt 15 Minuten nach und gibt dann 125,8 g eines kurzkettigen alpha omega silanolfunktionellen Phenylmethylöls eingelegt, das die durchschnittliche Zusammensetzung hat: HO-Si(Me)(Ph) [O-Si(Me)(Ph)]₄OSi(Me)(Ph)OH, das also insgesamt 6 Siliziumwiederholungseinheiten umfasst, von denen jede mit einer Phenyl und einer Methylgruppe substituiert ist und von denen die beiden terminalen Siliziumatome jeweils eine Hydroxylfunktion tragen und das ein mittleres Molekulargewicht von Mw = 800 g/mol bei Mn = 700 g/mol hat, und eine Viskosität von 503 mPas bei 25°C und Normaldruck von 1013 mbar aufweist.

Danach werden 250 g VE-Wasser innerhalb von 2 Stunden zudosiert. Zu Beginn wird nur sehr langsam dosiert, um eine übermäßige Salzsäuregasentwicklung zu vermeiden. Die eintretende Reaktion ist exotherm und wird durch die Fahrweise der Wasserzugabe so gesteuert, dass die Temperatur bis auf etwa 40°C ansteigt. Man rührt nach beendeter Wasserzugabe für 10 Minuten bei der dann gegebenen Temperatur nach und heizt anschließend auf Rückfluss auf (ca. 83°C Temperatur in der Reaktionsmischung). Nach zweistündigem Refluxieren werden ohne vorheriges Abkühlen 176,4 g Toluol und 175 g VE Wasser zugegeben, 10 Minuten nachgerührt und der Rührer dann ausgeschaltet. Man lässt die Phasen sich innerhalb von 40 Minuten ohne Rühren trennen. Die untere salzsaure Wasserphase wird abgetrennt. Sodann werden 500 g VE-Wasser zugesetzt, 10 Minuten gerührt, 45 Minuten ohne Rühren Phasen trennen lassen und die Wasserphase wiederum abgetrennt. Der HCl-Gehalt in der organischen Phase beträgt weniger als 7 ppm. Man engt die organische Phase am Rotationsverdampfer bei 150°C Ölbadtemperatur und 10 mbar Unterdruck 30 Minuten lang ein, und erhöht dann den Druck von 10 auf 20 mbar und die Ölbadtemperatur von 150°C auf 160°C. Man destilliert weitere 3 Stunden aus und erhält ein farbloses flüssiges Produkt mit einer Viskosität von 2600 mPas.
Nach SEC sind Mw = 2600 und Mn = 1200.

Der Silanolgehalt, der aufgrund von Signalüberlagerungen nur geschätzt werden kann, beträgt etwa 10030 ppm. Der Vinylgehalt ist 0,95 mmol/g, der Gehalt an siliziumgebundem Wasserstoff 1,02 mmol/g. Nach ²⁹Si-NMR ist die molare Zusammensetzung:
(CH₂=CH) Me₂SiO_{1/2}: 11,2 %
Me (H) SiO_{2/2}: 12,0 %
Ph(Me)SiO_{2/2}: 41,9 % (schließt Ph(Me)(RO)SiO_{1/2} mit ein)
Ph(OR)2SiO_{1/2}: 0,8 %
Ph(OR)SiO_{2/2}: 14,4 %
PhSiO_{3/2}: 19,7 %
wobei R hier hauptsächlich für Ethyl steht, daneben auch für Wasserstoff.

### Beispiel 4: erfindungsgemäß

In einem 4 1 4-Halsglasrundkolben mit Auslauf werden in 325,3 g Phenyltriethoxysilan PhSi(EtO)₃ (240 g/mol => Einwaage 1,36 mol), 325,3 g eines bei 23°C und Normaldruck von 1013 mbar festen Phenylsiliconharzes mit einem Molekulargewichtsmittel Mw von 2900 g/mol (Zahlenmittel Mn = 1500) und einer Glasübergangstemperatur von Tg = 52°C, das 5,5 Gew.-% siliziumgebundene Hydroxygruppen und 3,3 Gew.-% siliziumgebundene Ethoxygruppen enthält, und das aus 100 mol-% PhSiO_{3/2}-Einheiten besteht, wobei sich die Ethoxy- und die Hydroxygruppen auf die angegebenen Struktureinheiten verteilen, eingewogen und bei 60°C solange gerührt, bis sich das Phenylsiliconharz im Phenyltriethoxysilan gelöst hat.

Zu dieser Lösung werden 260 g eines linearen alpha omega silanolfunktionellen Phenylmethylöls eingelegt, das die durchschnittliche Zusammensetzung hat: HO-Si(Me)(Ph)[O-Si(Me)(Ph)]₁₄OSi(Me)(Ph)OH, das also insgesamt 16 Siliziumwiederholungseinheiten umfasst, von denen jede mit einer Phenyl und einer Methylgruppe substituiert ist und von denen die beiden terminalen Siliziumatome jeweils eine Hydroxylfunktion tragen und das ein mittleres Molekulargewicht von Mw = 2200 g/mol bei Mn = 1000 g/mol hat, und eine Viskosität von 1103 mPas bei 25°C und Normaldruck von 1013 mbar aufweist. Zu der so erhaltenen Zubereitung werden nacheinander zuerst 129 g 1,3-Divinyl-1,1,3,3-tetramethyldisiloxan [(CH₂=CH)Me₂Si]₂O (186 g/mol => Einwaage 0,69 mol) und dann 321 g Wasser zugegeben. Zu der so erhaltenen Zubereitung werden unter Rühren 130,7 g Vinyldimethylchlorsilan (CH₂=CH)Me₂SiCl (120,5 g/mol => Einwaage 1,38 mol) zudosiert. Die Dosierzeit beträgt 46 Minuten, die Temperatur steigt während der Dosierung aufgrund der Reaktionswärme von 22,3°C auf 41°C an, ohne dass von außen zugeheizt wird. Nach beendeter Dosierung wird auf Rückfluss erhitzt (Sumpftemperatur 85°C) und 30 Minuten auf Rückfluss gehalten. Anschließend werden 190 ml Destillat abgenommen. Die Rührguttemperatur steigt dabei auf 92°C, die Kopftemperatur auf 84°C. Man kühlt auf unter 80°C ab, gibt 533 ml Toluol zu, durchmischt für 15 Minuten, stellt den Rührer dann ab und wartet 30 Minuten ohne Rühren, bevor man die Wasserphase abtrennt. Zum Zeitpunkt der Phasentrennung beträgt die Temperatur der Mischung aufgrund von leichtem Zuheizen von außen noch 50°C.

Um die organische Phase zu waschen, werden 540 ml VE Wasser und 100 g Kochsalz (Natriumchlorid) zudosiert, 15 Minuten gerührt und der Rührer dann ausgeschaltet. Nach 30 Minuten Phasenseparation ohne Rühren, werden die Phasen getrennt. Der HCl-Gehalt der organischen Phase beträgt 3 ppm. 200 ml der Lösung werden zur Stabilitätsuntersuchung abgetrennt. Die Mischung erweist sich als stabil. Diese Menge wird in der weiteren Aufarbeitung nicht mehr berücksichtigt.

Man destilliert aus der organischen Phase 420 ml Destillat ab, kühlt auf unter 60°C ab und filtriert die warme Lösung dann mit einer Druckfilternutsche über eine Seitz K 100 Filterplatte mit Seitz Filterhilfsmittel FF ab. Die erhaltenen 672,9 g Filtrat sind klar und farblos. Der Festgehalt wird zu 87,9 Gew.-% bestimmt (1 g Substanz wurden dazu für eine halbe Stunde auf 200°C erhitzt und die Rückstandmenge gravimetrisch bestimmt). Das Produkt weißt laut SEC (Eluent THF) ein Molekulargewicht von Mw = 2600 g/mol und Mn = 1200 g/mol auf.

Der Silanolgehalt ist im ¹H-NMR aufgrund von Signalüberlagerungen nur ungefähr und beträgt etwa 2200 ppm. Der Vinylgehalt ist 1,17 mmol/g, der Gehalt an siliziumgebundenem Wasserstoff 0,92 mmol/g.

Nach ²⁹Si-NMR ist die molare Zusammensetzung:
(CH₂=CH)Me₂SiO_{1/2}: 14,8 %
Me₂(H)SiO_{1/2}: 11,7 %
Ph(Me)SiO_{2/2}: 27,2 % (schließt Ph(Me)(RO)SiO_{1/2} mit ein)
Ph (OR)₂SiO_{1/2}: 1, 6 %
Ph(OR)SiO_{2/2}: 18,2 %
PhSiO_{3/2}: 26,5 %
wobei R hier hauptsächlich für Ethyl steht, daneben auch für Wasserstoff.

**Beispiel 5: erfindungsgemäß** Vorgehensweise wie bei Beispiel 4 mit dem Unterschied, dass anstelle des linearen Phenylmethylpolysiloxans mit durchschnittlich 16 Wiederholungseinheiten ein kurzkettiges alpha omega silanolfunktionellen Phenylmethylöls verwendet wird, das die durchschnittliche Zusammensetzung hat: HO-Si(Me)(Ph) [O-Si(Me)(Ph)]₄OSi(Me) (Ph) OH, das also insgesamt 6 Siliziumwiederholungseinheiten umfasst, von denen jede mit einer Phenyl und einer Methylgruppe substituiert ist und von denen die beiden terminalen Siliziumatome jeweils eine Hydroxylfunktion tragen und das ein mittleres Molekulargewicht von Mw = 800 g/mol bei Mn = 700 g/mol hat, und eine Viskosität von 503 mPas bei 25°C und Normaldruck von 1013 mbar aufweist.

Man erhält 952 g eines klaren farblosen Produktes.
Der Festgehalt wird zu 89,2 Gew.-% bestimmt (1 g Substanz wurden dazu für eine halbe Stunde auf 200°C erhitzt und die Rückstandmenge gravimetrisch bestimmt).

Das Produkt weißt laut SEC (Eluent THF) ein Molekulargewicht von Mw = 1800 g/mol und Mn = 1100 g/mol auf.

Der Silanolgehalt ist im ¹H-NMR aufgrund von Signalüberlagerungen nur ungefähr und beträgt etwa 10100 ppm. Der Vinylgehalt ist 1,30 mmol/g, der Gehalt an siliziumgebundenem Wasserstoff 1,14 mmol/g.
Nach ²⁹Si-NMR ist die molare Zusammensetzung:
(CH₂=CH)Me₂SiO_{1/2}: 15,5 %
Me₂ (H) SiO_{1/2}: 13,4 %
Ph(Me)SiO_{2/2}: 25,1 % (schließt Ph(Me)(RO)SiO_{1/2} mit ein)
Ph(OR)₂SiO_{1/2}: 1,0 %
Ph (OR) SiO_{2/2}: 15,5 %
PhSiO_{3/2}: 29,5 %
wobei R hier hauptsächlich für Ethyl steht, daneben auch für Wasserstoff.

### Zubereitungsbeispiele

Nachstehend sind zur Veranschaulichung, keineswegs aber zur Einschränkung, Beispiele für Zubereitungen der Erfindung aufgeführt. In diesen Beispielen beziehen sich alle Angaben von Teilen oder Prozentsätzen, falls nicht anders angegeben, auf das Gewicht. Des Weiteren beziehen sich alle Angaben von Brechungsindizes auf eine Temperatur von 25 °C. Die Transmission wurde bestimmt, wie weiter oben offenbart. Der Festgehalt der toluolischen Harzlösungen wurde mittels des ¹H-NMR-Spektrums berechnet. Die Shore-Härten A und D wurden nach DIN 53505-A-87 bestimmt. Reißfestigkeiten wurden nach DIN 53504-85/Normstab S1 gemessen und Weiterreißfestigkeiten nach ASTM D 624 B-91 bestimmt.

### Zubereitungsbeispiel (Gegenbeispiel) 1: Zubereitung mit Harz nach Gegenbeispiel 1: nicht erfindungsgemäß

Es werden 90,0 g des in Gegenbeispiel 1 beschriebenen Harzes, 10,0 g eines linearen Siloxancopolymers, welches laut ²⁹Si-NMR-Spektrum durchschnittlich 60 Phenylmethylsiloxaneinheiten, 12 Dimethylsiloxaneinheiten und 2 Dimethylvinylsiloxan-Endgruppen besitzt sowie 0,025 g einer 80 %-igen Lösung von 1-Ethinylcyclohexanol in Trimethylsilanol und 0,0025 g eines Platin (0)-sym. Tetramethyl-divinyl-disiloxankomplexes (Karstedt-Katalysator) mit einem Gehalt von 20 Gew.-% Platin, berechnet als elementares Metall, homogen vermischt. Die Zubereitung hatte einen Brechungsindex von 1,5175.

Die so erhaltene Mischung wird in eine teflonbeschichtete Edelstahlform von 2 mm Tiefe und einer Aussparung von 6 mm Tiefe gegossen und die geschlossene Edelstahlform zur Formgebung zunächst 15 Minuten bei 165 °C und einem Druck von 5,45 MPa in einer Laborpresse anvulkanisiert. Anschließend erfolgt die restliche Aushärtung drucklos für 6 Stunden bei 150 °C im Umlufttrockenschrank.

Nach einer Konditionierungszeit von 16 Stunden wurden die mechanischen Eigenschaften bestimmt. Das Vulkanisat war sehr spröde. Der 6 mm dicke Prüfkörper hatte eine Härte von 70 Shore D und an der 2 mm dicken Folie wurde eine Reißfestigkeit von 7,8 N/mm², eine Reißdehnung von 3 % und ein Weiterreißwiderstand von 15,2 N/mm gemessen. Die Transmission lag bei 550 nm bei 90,9 %.

### Zubereitungsbeispiel 2: Zubereitung mit Harz nach Beispiel 2: erfindungsgemäß

Es werden 60,0 g des in Beispiel 2 beschriebenen Flüssigharzes und 40,0 g eines linearen Siloxancopolymers, welches laut ²⁹Si-NMR-Spektrum durchschnittlich 60 Phenylmethylsiloxaneinheiten, 12 Dimethylsiloxaneinheiten und 2 Dimethylvinylsiloxan-Endgruppen besitzt sowie 0,025 g einer 80 %-igen Lösung von 1-Ethinylcyclohexanol in Trimethylsilanol und 0,0025 g eines Platin(0)/sym. Tertamethyldivinyldisiloxan-Komplexes (Karstedt-Katalysator) mit einem Gehalt von 20 Gew.-% Platin, berechnet als elementares Metall, homogen vermischt. Die Zubereitung hatte einen Brechungsindex von 1,5325.

Die so erhaltene Mischung wird in eine teflonbeschichtete Edelstahlform von 2 mm Tiefe und einer Aussparung von 6 mm Tiefe gegossen und die geschlossene Edelstahlform zur Formgebung zunächst 15 Minuten bei 165 °C und einem Druck von 5,45 MPa in einer Laborpresse anvulkanisiert. Anschließend erfolgt die restliche Aushärtung drucklos für 6 Stunden bei 150 °C im Umlufttrockenschrank.

Nach einer Konditionierungszeit von 16 Stunden bei Raumtemperatur hatte der 6 mm dicke Prüfkörper eine Härte von 12 Shore D und an der 2 mm dicken Folie wurde eine Reißfestigkeit von 1,3 N/mm², eine Reißdehnung von 22 % und ein Weiterreißwiderstand von 3,4 N/mm gemessen. Die Transmission lag bei 550 nm bei 96,2 %.

### Zubereitungsbeispiel 3: Zubereitung mit Harz nach Beispiel 3: erfindungsgemäß

Es werden 60,0 g des in Beispiel 3 beschriebenen Flüssigharzes und 40,0 g eines linearen Siloxancopolymers, welches laut ²⁹Si-NMR-Spektrum durchschnittlich 60 Phenylmethylsiloxaneinheiten, 12 Dimethylsiloxaneinheiten und 2 Dimethylvinylsiloxan-Endgruppen besitzt sowie 0,025 g einer 80 %-igen Lösung von 1-Ethinylcyclohexanol in Trimethylsilanol und 0,0025 g eines Platin(0)/sym. Tertamethyldivinyldisiloxan-Komplexes (Karstedt-Katalysator) mit einem Gehalt von 20 Gew.-% Platin, berechnet als elementares Metall, homogen vermischt. Die Zubereitung hatte einen Brechungsindex von 1,5335.

Die so erhaltene Mischung wird in eine teflonbeschichtete Edelstahlform von 2 mm Tiefe und einer Aussparung von 6 mm Tiefe gegossen und die geschlossene Edelstahlform zur Formgebung zunächst 15 Minuten bei 165 °C und einem Druck von 5,45 MPa in einer Laborpresse anvulkanisiert. Anschließend erfolgt die restliche Aushärtung drucklos für 6 Stunden bei 150 °C im Umlufttrockenschrank.

Nach einer Konditionierungszeit von 16 Stunden bei Raumtemperatur hatte der 6 mm dicke Prüfkörper eine Härte von 14 Shore D und an der 2 mm dicken Folie wurde eine Reißfestigkeit von 1,2 N/mm², eine Reißdehnung von 29 % und ein Weiterreißwiderstand von 3,0 N/mm gemessen. Die Transmission lag bei 550 nm bei 97,1 %.

### Zubereitungsbeispiel 4: Zubereitung mit Harz nach Beispiel 4: erfindungsgemäß

Es werden 65,4 g (Festgehalt: 60 g) einer 91,7-%igen toluolischen Lösung des in Beispiel 4 beschriebenen Harzes, 40,0 g eines linearen Siloxancopolymers, welches laut ²⁹Si-NMR-Spektrum durchschnittlich 60 Phenylmethylsiloxaneinheiten, 12 Dimethylsiloxaneinheiten und 2 Dimethylvinylsiloxan-Endgruppen besitzt und 2,2 g 1,4-Bis(dimethylsilyl)benzol sowie 0,026 g einer 80 %-igen Lösung von 1-Ethinylcyclohexanol in Trimethylsilanol und 0,0026 g eines Platin(0)/sym. Tertamethyldivinyldisiloxan-Komplexes (Karstedt-Katalysator) mit einem Gehalt von 20 Gew.-% Platin, berechnet als elementares Metall, homogen vermischt. Die Zubereitung hatte einen Brechungsindex von 1,5289.

Die so erhaltene Mischung wird in eine teflonbeschichtete Edelstahlform von 2 mm Tiefe und einer Aussparung von 6 mm Tiefe gegossen und die geschlossene Edelstahlform zur Formgebung zunächst 15 Minuten bei 165 °C und einem Druck von 5,45 MPa in einer Laborpresse anvulkanisiert. Anschließend erfolgt die restliche Aushärtung drucklos für 6 Stunden bei 150 °C im Umlufttrockenschrank.

Nach einer Konditionierungszeit von 16 Stunden bei Raumtemperatur hatte der 6 mm dicke Prüfkörper eine Härte von 18 Shore D und an der 2 mm dicken Folie wurde eine Reißfestigkeit von 1,3 N/mm², eine Reißdehnung von 47 % und ein Weiterreißwiderstand von 2,8 N/mm gemessen. Die Transmission lag bei 550 nm bei 98,2 %.

### Zubereitungsbeispiel 5: Zubereitung mit Harz nach Beispiel 5: erfindungsgemäß

Es werden 65,9 g (Festgehalt: 60 g) einer 91,0-%igen toluolischen Lösung des in Beispiel 5 beschriebenen Harzes, 40,0 g eines linearen Siloxancopolymers, welches laut ²⁹Si-NMR-Spektrum durchschnittlich 60 Phenylmethylsiloxaneinheiten, 12 Dimethylsiloxaneinheiten und 2 Dimethylvinylsiloxan-Endgruppen besitzt und 2,0 g 1,4-Bis(dimethylsilyl)benzol sowie 0,026 g einer 80 %-igen Lösung von 1-Ethinylcyclohexanol in Trimethylsilanol und 0,0026 g eines Platin(0)/sym. Tertamethyldivinyldisiloxan-Komplexes (Karstedt-Katalysator) mit einem Gehalt von 20 Gew.-% Platin, berechnet als elementares Metall, homogen vermischt. Die Zubereitung hatte einen Brechungsindex von 1,5280.

Die so erhaltene Mischung wird in eine teflonbeschichtete Edelstahlform von 2 mm Tiefe und einer Aussparung von 6 mm Tiefe gegossen und die geschlossene Edelstahlform zur Formgebung zunächst 15 Minuten bei 165 °C und einem Druck von 5,45 MPa in einer Laborpresse anvulkanisiert. Anschließend erfolgt die restliche Aushärtung drucklos für 6 Stunden bei 150 °C im Umlufttrockenschrank.

Nach einer Konditionierungszeit von 16 Stunden bei Raumtemperatur hatte der 6 mm dicke Prüfkörper eine Härte von 15 Shore D und an der 2 mm dicken Folie wurde eine Reißfestigkeit von 1,2 N/mm², eine Reißdehnung von 46 % und ein Weiterreißwiderstand von 2,5 N/mm gemessen. Die Transmission lag bei 550 nm bei 97,8 %.

## Patentansprüche

1. Additionsvernetzende Siliconharzzusammensetzungen enthaltend A) mindestens ein verzweigtes, selbstvernetzendes Organopolysiloxan der allgemeinen Formel (I)
(R¹R²R³SiO_{1/2})_{M} (R⁴R⁵SiO_{2/2})_{D} (R⁶SiO_{3/2})_{T} (SiO_{4/2})_{Q} (I),
wobei
- R¹ bis R⁶ unabhängig voneinander, einwertige, gegebenenfalls substituierte Kohlenwasserstoffreste, die durch Heteroatome unterbrochen sein können, eine OH-Gruppe oder ein Wasserstoff-Atom,
- M, D, T, und Q eine Zahl von 0 bis <1,
bedeuten,
mit der Maßgabe, dass M+D+T+Q=1 und Q+T>0 erfüllt ist, und
mit der Maßgabe, dass ein Molekül A) als Reste R¹ bis R⁶
- mindestens zwei Alkenyl-Gruppen,
- mindestens zwei Wasserstoff-Atome, und
- mindestens eine Aryl-Gruppe,
enthält,
und mit der Maßgabe, dass mindestens 5 mol-% aller Teileinheiten von A) solche der Form (R⁴R⁵SiO_{2/2})_{D} sind, mit der Maßgabe, dass mindestens 6 mol% aller Teileinheiten (R⁴R⁵SiO_{2/2})_{D} als Kettensegmente aus 3 bis 200 aneinandergereihten Teileinheiten in A) vorliegen und die Reste R⁴ und R⁵ dieser Teileinheiten, die als Kettensegmente vorliegen, weder ein Wasserstoff-Atom noch ein Alkenylrest sind,
- wobei das molare Verhältnis der siliziumgebundenen Alkenyl-Gruppen tragenden Wiederholungseinheiten zu den siliziumgebundene Wasserstoffatome tragenden Wiederholungseinheiten mindestens 0,75 beträgt; und
- wobei der Molanteil der mindestens einen Arylrest tragenden Siliziumatome zur Gesamtanzahl der Siliziumatome mindestens 30% beträgt; und
- wobei der molare Anteil der Alkylgruppen an der Gesamtzahl der siliziumgebundenen Reste höchstens 70% beträgt,
C) eine ausreichende Menge mindestens eines die Anlagerung von Si-gebundenem Wasserstoff an aliphatische Doppelbindungen fördernden Katalysators,
wobei in der additionsvernetzenden Siliconharzzusammensetzung das molare Verhältnis von siliziumgebundenen Alkenyl-Gruppen zu siliziumgebundenen Wasserstoff-Atomen zwischen 0,5:1 und 2:1 liegt.

2. Additionsvernetzende Siliconharzzusammensetzungen gemäß Anspruch 1 welche zusätzlich mindestens ein Flexipolymer D) der allgemeinen Formel (IV) enthält,
(R¹¹_{w}R¹²_{x*}SiO_{1/2})_{M*} (R¹¹_{y}R¹²_{z}SiO_{2/2})_{D*} (R¹³SiO_{3/2})_{T*} (IV),
wobei
- R¹¹ und R¹² und R¹³ unabhängig voneinander, gegebenenfalls substituierte Kohlenwasserstoffreste, die durch Heteroatome unterbrochen sein können, und kein Wasserstoff-Atom;
- w und x* jeweils eine Zahl 0, 1, 2 oder 3, mit w+x* = 3;
- y und z jeweils eine Zahl 0, 1, 2 oder 3, mit y+z = 2;
- M*, D*, und T* eine Zahl von 0 bis <1, mit M*+D*+T*=1 bedeuten,
mit der Maßgabe, dass pro Molekül D)
- mindestens zwei Alkenyl-Gruppen als R¹¹, und
- mindestens eine Aryl-Gruppe als R¹² oder R¹³
enthalten ist.

3. Verfahren zur Herstellung der additionsvernetzenden Siliconharzzusammensetzung gemäß Anspruch 1 oder 2, **dadurch gekennzeichnet, dass** die Komponenten A) und C) oder A), C) und D) vermischt werden.

4. Verwendung der additionsvernetzenden Siliconharzzusammensetzung gemäß Anspruch 1 oder 2 als Vergussmasse in elektrischen und elektronischen Anwendungen.

5. Verwendung der additionsvernetzenden Siliconharzzusammensetzung gemäß Anspruch 1 oder 2 als Vergussmasse zur Herstellung von LEDs.

## Claims

1. Addition-crosslinking silicone resin compositions comprising
A) at least one branched, self-crosslinking organopolysiloxane of the general formula (I)
(R¹R²R³SiO_{1/2})_{M} (R⁴R⁵SiO_{2/2})_{D} (R⁶SiO_{3/2})_{T} (SiO_{4/2})_{Q} (I),
where
- R¹ to R⁶ are mutually independently monovalent, optionally substituted hydrocarbon moieties which can have interruption by heteroatoms, or are an OH group, or a hydrogen atom,
- M, D, T, and Q are a number from 0 to < 1,
with the proviso that M+D+T+Q=1 and Q+T>0, and
with the proviso that a molecule A) comprises, as moieties R¹ to R⁶,
- at least two alkenyl groups,
- at least two hydrogen atoms, and
- at least one aryl group,
and with the proviso that at least 5 mol% of all of the subunits of A) take the form (R⁴R⁵SiO_{2/2})_{D}, with the proviso that at least 6 mol% of all of the subunits (R⁴R⁵SiO_{2/2})_{D} are present as chain segments made of from 3 to 200 adjacent subunits in A), and the moieties R⁴ and R⁵ of said subunits present as chain segments are neither a hydrogen atom nor an alkenyl moiety,
- where the molar ratio of the silicon-bonded repeating units bearing alkenyl groups to the repeating units bearing silicon-bonded hydrogen atoms is at least 0.75; and
- where the molar proportion of the silicon atoms bearing at least one aryl moiety to the total number of the silicon atoms is at least 30%; and
- where the molar proportion of the alkyl groups, based on the total number of the silicon-bonded moieties is at most 70%,
C) a sufficient quantity of at least one catalyst that promotes the addition reaction of Si-bonded hydrogen onto aliphatic double bonds,
where the molar ratio of silicon-bonded alkenyl groups to silicon-bonded hydrogen atoms in the addition-crosslinking silicone resin composition is from 0.5:1 to 2:1.

2. Addition-crosslinking silicone resin compositions according to Claim 1 which also comprises at least one flexipolymer D) of the general formula (IV)
(R¹¹_{w}R¹²_{x*}SiO_{1/2})_{M*} (R¹¹_{y}R¹²_{z}SiO_{2/2})_{D*} (R¹³SiO_{3/2})_{T*} (IV),
where
- R¹¹ and R¹² and R¹³ are mutually independently optionally substituted hydrocarbon moieties which can have interruption by heteroatoms, and are not a hydrogen atom;
- w and x* are respectively a number 0, 1, 2, or 3, where w+x* = 3;
- y and z are respectively a number 0, 1, 2, or 3, where y+z = 2;
- M*, D*, and T* are a number from 0 to <1, where M*+D*+T*=1,
with the proviso that, per molecule D),
- there are at least two alkenyl groups present as R¹¹, and
- there is at least one aryl group present as R¹² or R¹³.

3. Process for the production of the addition-crosslinking silicone resin composition according to Claim 1 or 2, **characterized in that** components A) and C) or A), C) and D) are mixed.

4. Use of the addition-crosslinking silicone resin composition according to Claim 1 or 2 as potting composition in electrical and electronic applications.

5. Use of the addition-crosslinking silicone resin composition according to Claim 1 or 2 as potting composition for the production of LEDs.

## Revendications

1. Compositions de résine silicone réticulables par addition, contenant
A) au moins un organopolysiloxane ramifié, autoréticulable, de formule générale (I)
(R¹R²R³SiO_{1/2})_{M} (R⁴R⁵SiO_{2/2})_{D} (R⁶SiO_{3/2})_{T} (SiO_{4/2})_{Q} (I),
dans laquelle
- R¹ à R⁶ représentent indépendamment les uns des autres des radicaux hydrocarbonés monovalents, éventuellement substitués, qui peuvent être interrompus par des hétéroatomes, un groupe OH ou un atome d'hydrogène,
- M, D, T et Q représentent un nombre valant de 0 à <1,
étant entendu que M+D+T+Q=1 et Q+T>0, et
étant entendu qu'une molécule A) contient comme radicaux R¹ à R⁶
- au moins deux groupes alcényle,
- au moins deux atomes d'hydrogène et
- au moins un groupe aryle,
et étant entendu qu'au moins 5 % en moles de toutes les unités partielles de A) sont celles de la forme (R⁴R⁵SiO_{2/2})_{D}, étant entendu qu'au moins 6 % en moles de toutes les unités partielles (R⁴R⁵SiO2/2)_{D} se trouvent dans A) sous forme de segments en chaîne de 3 à 200 unités partielles qui se succèdent et les radicaux R⁴ et R⁵ de ces unités partielles qui se trouvent sous forme de segments en chaîne ne sont ni un atome d'hydrogène ni un radical alcényle,
- le rapport molaire des unités répétitives portant des groupes alcényle liés au silicium aux unités répétitives portant des atomes d'hydrogène liés au silicium valant au moins 0,75 ; et
- la proportion molaire des atomes de silicium portant au moins un radical aryle par rapport au nombre total des atomes de silicium valant au moins 30 % ; et
- la proportion molaire des groupes alkyle par rapport au nombre total des radicaux liés au silicium valant au maximum 70 %,
C) une quantité suffisante d'au moins un catalyseur favorisant la fixation par addition d'hydrogène lié à Si sur des doubles liaisons aliphatiques,
dans la composition de résine silicone réticulable par addition, le rapport molaire des groupes alcényle liés au silicium aux atomes d'hydrogène liés au silicium étant compris entre 0,5:1 et 2:1.

2. Compositions de résine silicone réticulables par addition selon la revendication 1, contenant en outre au moins un flexipolymère D) de formule générale (IV),
(R¹¹_{w}R¹²_{x*}SiO_{1/2})_{M*} (R¹¹_{y}R¹²_{z}SiO_{2/2})_{D*} (R¹³SiO_{3/2})_{T*} (IV),
dans laquelle
- R¹¹ et R¹² et R¹³ représentent chacun indépendamment des radicaux hydrocarbonés éventuellement substitués, qui peuvent être interrompus par des hétéroatomes, et ne représentent pas un atome d'hydrogène ;
- w et x* représentent chacun un nombre valant 0, 1, 2 ou 3, avec w+x* = 3 ;
- y et z représentent chacun un nombre valant 0, 1, 2 ou 3, avec y+z = 2 ;
- M*, D* et T* représentent un nombre valant de 0 à <1, avec M*+D*+T*=1,
étant entendu que sont contenus par molécule D)
- au moins deux groupes alcényle en tant que R¹¹ et
- au moins un groupe aryle en tant que R¹² ou R¹³.

3. Procédé pour la préparation de la composition de résine silicone réticulable par addition selon la revendication 1 ou 2, **caractérisé en ce qu'**on mélange les composants A) et C) ou A), C) et D).

4. Utilisation de la composition de résine silicone réticulable par addition selon la revendication 1 ou 2 en tant que matière à couler dans des applications électriques et électroniques.

5. Utilisation de la composition de résine silicone réticulable par addition selon la revendication 1 ou 2 en tant que matière à couler dans la fabrication de LED.
